# EUROPEAN PATENT APPLICATION

(11) **EP 2 418 688 A1**
(43) Date of publication of application: **15.02.2012**
(21) Application number: 10761672.4
(22) Date of filing: 05.04.2010
(51) Int. Cl.: H01L 31/042

(54) **INTERCONNECT SHEET, SOLAR CELL WITH INTERCONNECT SHEET, SOLAR MODULE, AND METHOD OF PRODUCING SOLAR CELL WITH INTERCONNECT SHEET**

(30) Priority: 08.04.2009 JP 2009094184
(71) Applicant: Sharp Kabushiki Kaisha, Osaka-shi, Osaka 545-8522 (JP)
(72) Inventor: SAINOO, Yasushi, Osaka 545-8522 (JP); DOTTA, Yoshihisa, Osaka 545-8522 (JP); TSUNEMI, Akiko, Osaka 545-8522 (JP); NISHINA, Tomohiro, Osaka 545-8522 (JP)
(74) Representative: Schiuma, Daniele Wolfgang
(86) International application number: PCT/JP2010/056172
(87) International publication number: WO 2010/116973

(57) **Abstract**

There is provided a wiring sheet (10) provided with a wiring (16) on an insulating base material (11) for electrically connecting a plurality of back electrode type solar cells (20), the wiring sheet (10) having a plurality of cell mounting portions (10a) provided with the back electrode type solar cells (20), the wiring sheet (10) being provided with an insulation layer (101) on a cell mounting side between adjacent cell mounting portions (10a). There is provided a wiring sheet (10) for a back electrode type solar cell, a solar cell with the wiring sheet, a solar cell module, and a method for fabricating the solar cell with the wiring sheet, that can reduce/prevent unwanted contact between the back electrode type solar cell (20) disposed on the wiring sheet (10) and the wiring (16) of the wiring sheet (10).

## Description

### TECHNICAL FIELD

The present invention relates to wiring sheets, solar cells with wiring sheets, solar cell modules, and methods for fabricating solar cells with wiring sheets.

### BACKGROUND ART

In recent years, development of clean energy is demanded for environmental issues such as shortage of energy resources, increasing CO₂ in the atmosphere, and the like, and in particular, solar photovoltaic power generation employing solar cell modules are developed, put to practical use and advanced as a new energy resource.

Such a solar cell module is configured of solar cells, the mainstream of which has conventionally been a solar cell for example having a monocrystalline or polycrystalline silicon substrate having a photoreceptive surface with an impurity of a conduction type opposite to that of the silicon substrate diffused therein to provide a pn junction, and a back surface opposite to the photoreceptive surface, with the surfaces provided with electrodes, respectively, i.e., a bifacial solar cell. Furthermore, in recent years, a solar cell having a silicon substrate having a back surface with both an electrode for p type and an electrode for n type, i.e., a so called back electrode type solar cell, is also being developed.

For example, U.S. patent No. 5951786 (patent literature 1) discloses a solar cell module including an insulating base material, an electrically conductive wiring patterned on a surface of the insulating base material, and a back electrode type solar cell overlying the wiring and electrically connected thereto.

### CITATION LIST

### PATENT LITERATURE

PTL 1: U.S. Patent No. 5951786

### SUMMARY OF INVENTION

### TECHNICAL PROBLEM

Patent literature 1 describes a configuration of a solar cell module that can be fabricated for example as follows:

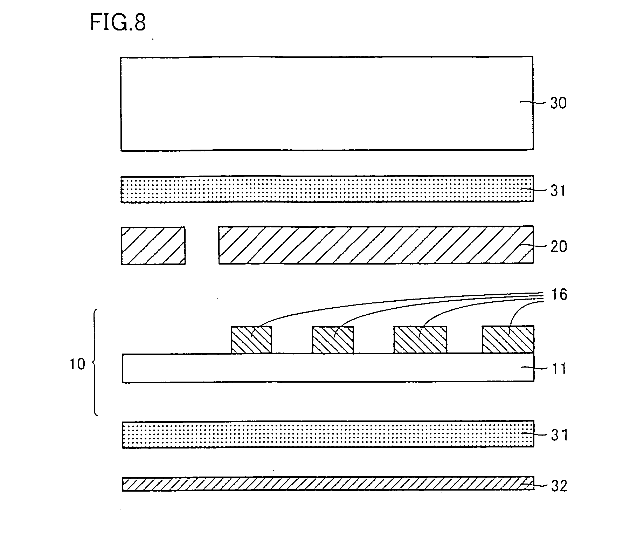

With reference to Fig. 8, initially, an insulating base material 11 formed for example of a polymeric material is prepared and on a surface thereof a patterned wiring 16 is formed.

Subsequently, the electrodes (not shown) of a plurality of back electrode type solar cells 20 are bonded with an electrically conductive adhesive to wiring 16 patterned on the surface of insulating base material 11. The plurality of back electrode type solar cells 20 are thus electrically connected to wiring 16 on the surface of insulating base material 11 to fabricate solar cells with a wiring sheet.

The back electrode type solar cells electrically connected to wiring 16 on the surface of insulating base material 11 are pressed to a sealing material 31 disposed between a glass or similar, transparent substrate 30 and back electrode type solar cells 20 and between a back surface protection sheet 32 and a wiring sheet 10 and are heated. The back electrode type solar cells with the wiring sheet (i.e., back electrode type solar cells 20 and wiring sheet 10) are thus sealed in the sealing material. A solar cell module is thus fabricated.

In general, a wiring sheet can be formed of an insulating film material, and copper, aluminum or similar foil of approximately 50 µm or smaller in thickness bonded thereto, and can be etched to have a circuit pattern thereon. A method has been studied to bond cells' electrodes with an electrically conductive adhesive or the like in accordance with the sheet's electrode pattern. This method, in contrast to a conventional solar cell wiring method, does not require connecting from the cell's back electrode to front electrode via a tub line and thus allows cells to be spaced by a distance smaller than conventional. This allows a solar cell module to provide more efficient conversion and can reduce its construction cost per output.

A typical solar cell module has cells sealed by a sealing material. More specifically, the cells are sealed in the step for example of sandwiching a wired cell group by the sealing material in the form of sheet, applying pressure and in that condition, applying a temperature of approximately 120-150°C to melt the sealing material, and cooling it to room temperature and thus setting it. This sealing step may thermally contract/expand the wiring sheet. Furthermore, a temperature cycle caused in a market environment may also thermally contract/expand the wiring sheet. In some case, there is even a possibility that the wiring sheet is thermally deformed to project toward solar cells and thus has a wiring brought into contact with a portion other than an electrode of a solar cell.

In other words, the sealing step involving a heat treatment, setting the solar cell module in an environment of high temperature, and the like thermally contract/expand the wiring sheet, which may result in unwanted contact between a back electrode type solar cell and a wiring of the wiring sheet, and furthermore, unsatisfactory insulation, electrical leakage, and short circuit.

Furthermore, if a back electrode type solar cell has an electrode misaligned from a wiring of the wiring sheet, the wiring and the electrode contact each other in a reduced area resulting in an increased contact resistance, and if a cell has an electrode misaligned in a large amount, the electrodes different in conduction type (p type/n type) and a wiring may short-circuit.

Such misalignment includes initial misalignment, and misalignment in a process, an environment for installation, and the like. Initial misalignment is attributed to a cell's dimensional tolerance, the precision in forming the cell's electrodes, a wiring's dimensional tolerance, the precision in forming the wiring, and the precision in mounting the cell on the wiring. Accordingly, the wiring must be spaced to avoid short circuit with the combination of these tolerances considered.

Misalignment in a process, an environment for installation, and the like is caused for example when the aforementioned process involving a heat treatment thermally contracts/expands the wiring sheet and as a result a back electrode type solar cell may have an electrode misaligned relative to a wiring of the wiring sheet. In addition, the aforementioned sealing step fluidizes the sealing material, which may also misalign the wiring sheet relative to a back electrode type solar cell or vice versa.

In view of the above circumstances, the present invention contemplates a wiring sheet for a back electrode type solar cell, a solar cell with the wiring sheet, a solar cell module, and a method for fabricating the solar cell with the wiring sheet, that can reduce/prevent unwanted contact between the back electrode type solar cell disposed on the wiring sheet and a wiring of the wiring sheet.

The present invention also contemplates a wiring sheet for a back electrode type solar cell, a solar cell with the wiring sheet, a solar cell module, and a method for fabricating the solar cell with the wiring sheet, that can reduce/prevent misalignment of an electrode of the back electrode type solar cell relative to a wiring of the wiring sheet.

### SOLUTION TO PROBLEM

The present invention provides a wiring sheet including an insulating base material and a wiring disposed on the insulating base material for electrically connecting a back electrode type solar cell, the wiring sheet having a plane with a cell mounting portion for mounting the back electrode type solar cell thereon, the wiring sheet being provided with an insulation layer at the plane on a surface of at least a portion of a region excluding the cell mounting portion, the insulation layer extending to cover at least a portion of a peripheral region of the cell mounting portion.

Preferably, the insulation layer has a surface similar in color to a photoreceptive surface of the back electrode type solar cell.

Preferably, the insulation layer has a white surface.

Preferably, the wiring sheet further includes a plurality of cell mounting portions and is provided with the insulation layer between adjacent ones of the cell mounting portions.

Preferably, the insulation layer is provided on the wiring.

Preferably, the wiring includes a comb-like portion formed of a plurality of teeth for electrical connection to the back electrode type solar cell and a connection portion connecting the teeth, and the insulation layer is provided in a region including a portion at which the teeth are connected to the connection portion.

Furthermore, the present invention provides a solar cell with a wiring sheet, including: a wiring sheet having an insulating base material and a wiring provided on the insulating base material; and a back electrode type solar cell having a photoreceptive surface and an opposite surface provided with an electrode, the wiring sheet being provided with the back electrode type solar cell on a plane, the wiring sheet being provided with an insulation layer at the plane on a surface of at least a portion of a region excluding a cell mounting portion on which said back electrode type solar cell is mounted, the insulation layer partially extending to the cell mounting portion between the back electrode type solar cell and the wiring sheet.

Preferably, the insulation layer has a surface similar in color to the photoreceptive surface of the back electrode type solar cell.

Preferably, the insulation layer has a white surface.

Preferably, the solar cell with the wiring sheet further includes a plurality of back electrode type solar cells and is provided with the insulation layer between adjacent ones of the back electrode type solar cells.

Preferably, the insulation layer is provided on the wiring.

Preferably, the wiring includes a comb-like portion formed of a plurality of teeth and a connection portion connecting the teeth, the electrode forms a group of electrodes connected to the wiring at the plurality of teeth, and at least a portion of a region outer than the group of electrodes on a surface of the back electrode type solar cell provided with the group of electrodes is covered with the insulation layer.

Furthermore, the present invention provides a solar cell module having the solar cell with the wiring sheet as described above sealed with a sealing material.

Furthermore, the present invention provides a method for fabricating a solar cell with a wiring sheet, including a wiring sheet having an insulating base material and a wiring provided on the insulating base material, and a back electrode type solar cell having a photoreceptive surface and an opposite surface provided with an electrode, the method including the steps of: providing an insulation layer on a plane having a cell mounting portion for mounting the back electrode type solar cell thereon; and disposing the back electrode type solar cell on the wiring sheet such that a peripheral region of the back electrode type solar cell is superposed on a portion of the insulation layer.

### ADVANTAGEOUS EFFECTS OF INVENTION

The present invention can provide a wiring sheet having an insulation layer at a cell mounting side between cell mounting portions so that if the wiring sheet is deformed the wiring sheet is prevented from having a wiring brought into contact with a portion of a back electrode type solar cell other than a wiring and thus reduces/prevents unsatisfactory insulation, electrical leakage and short circuit, and a product having excellent characteristics can thus be implemented.

Furthermore, the present invention can provide a wiring sheet having an insulation layer at a cell mounting side between cell mounting portions so that it reduces/prevents misalignment between the wiring sheet and a back electrode type solar cell and hence wiring-electrode contact resistance reduction, short circuit and the like, and a product having excellent characteristics can thus be implemented.

### BRIEF DESCRIPTION OF DRAWINGS

Fig. 1(a) is a schematic plan view of one example of a wiring sheet in accordance with the present invention, as seen at a side thereof provided with wiring, and Fig. 1 (b) is a schematic cross section taken along a line B-B shown in Fig. 1 (a).
Fig. 2(a) is a schematic cross section of one example of a back electrode type solar cell electrically connected to a wiring of a wiring sheet in accordance with the present invention, and Fig. 2(b) is a schematic plan view of one example of a back surface of a semiconductor substrate of the back electrode type solar cell shown in Fig. 2(a).
Fig. 3(a) is a schematic plan view of another example of the back surface of the semiconductor substrate of the back electrode type solar cell shown in Fig. 2(a), and Fig. 3(b) is a schematic plan view of still another example of the back surface of the semiconductor substrate of the back electrode type solar cell shown in Fig. 2(a).
Fig. 4(a) is a schematic plan view of one example of a solar cell with a wiring sheet in accordance with the present invention, as seen at its photoreceptive surface, and Fig. 4(b) is a schematic cross section taken along a line B-B shown in Fig. 4(a).
Figs. 5(a) and 5(b) are schematic cross sections of an example of a solar cell with a wiring sheet in accordance with the present invention, taken along a line A-A shown in Fig. 4(a).
Figs. 6(a) and 6(b) are schematic cross sections for illustrating one example of a method for fabricating one example of a solar cell module in accordance with the present invention.
Figs. 7(a) and 7(b) are schematic cross sections for illustrating another example of the method for fabricating one example of the solar cell module in accordance with the present invention.
Fig. 8 is a schematic cross section for illustrating a method for fabricating a solar cell module employing a wiring sheet.
Fig. 9 is a schematic view of a wiring sheet with back electrode type solar cells disposed thereon, as seen at a side provided with the cells.

### DESCRIPTION OF EMBODIMENTS

Hereinafter, the present invention will be described in embodiments. In the figures, identical reference characters denote identical or corresponding components.

### Wiring Sheet

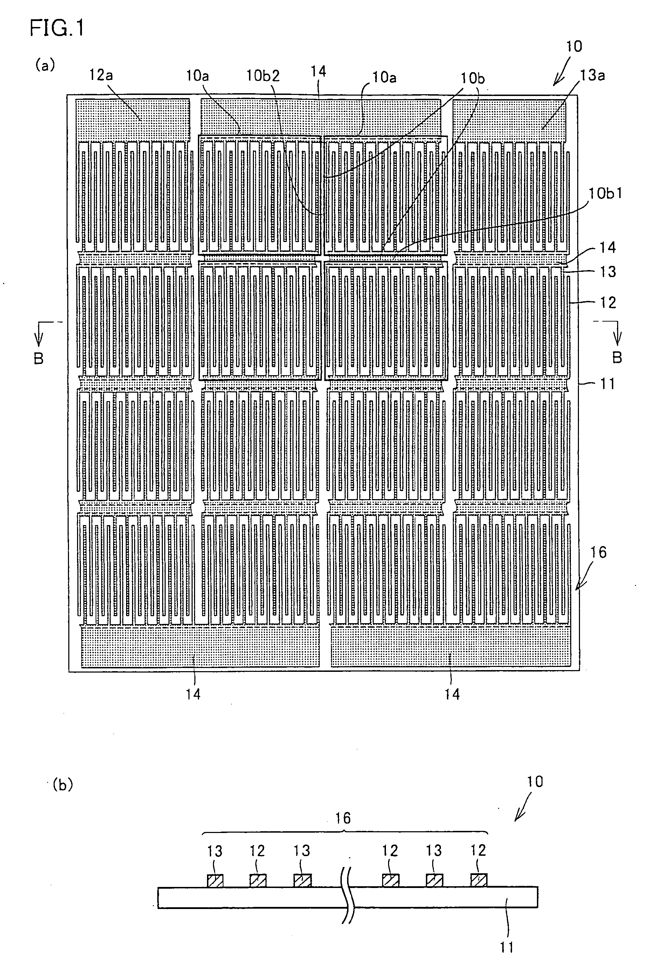

Fig. 1(a) is a schematic plan view of one example of a wiring sheet in accordance with the present invention, as seen at a side thereof provided with wiring. As shown in Fig. 1(a), a wiring sheet 10 includes an insulating base material 11, and a wiring 16 including a wiring for n type 12, a wiring for p type 13 and a wiring for connection 14.

Note that the wiring for n type 12, the wiring for p type 13 and the wiring for connection 14 are all conductive, and the wiring for n type 12 and the wiring for p type 13 are each provided in the form of a comb and the wiring for connection 14 in the form of a strip. Furthermore, except for a wiring for n type 12a and a wiring for p type 13b located at an end of wiring sheet 10, adjacent wirings for n and p types 12 and 13 3 are electrically connected by the wiring for connection 14.

Furthermore, wiring sheet 10 has the wiring for n type 12 and the wiring for p type 13 disposed such that the comb-like wirings for n and p types 12 and 13 have their respective teeth alternating with each other, one by one. As a result, the comb-like wirings for n and p types 12 and 13 will have their respective teeth alternating with each other, one by one, with a predetermined distance therebetween.

Wiring sheet 10 thus includes a comb-like portion of the wiring for n type 12 and that of the wiring for p type 13 to correspond to a cell mounting portion provided with a respective, single back electrode type solar cell. Wiring sheet 10 as a whole has a plurality of sets of such comb-like portions. Each comb-like portion has a plurality of teeth connected together by the wiring for connection 14, i.e., the wiring for connection 14 corresponds to a connection portion connecting the plurality of teeth.

Fig. 1(b) is a schematic cross section taken along a line B-B shown in Fig. 1(a). As shown in Fig. 1(b), for wiring sheet 10, the wiring for n type 12 and the wiring for p type 13 are provided only on one surface of insulating base material 11.

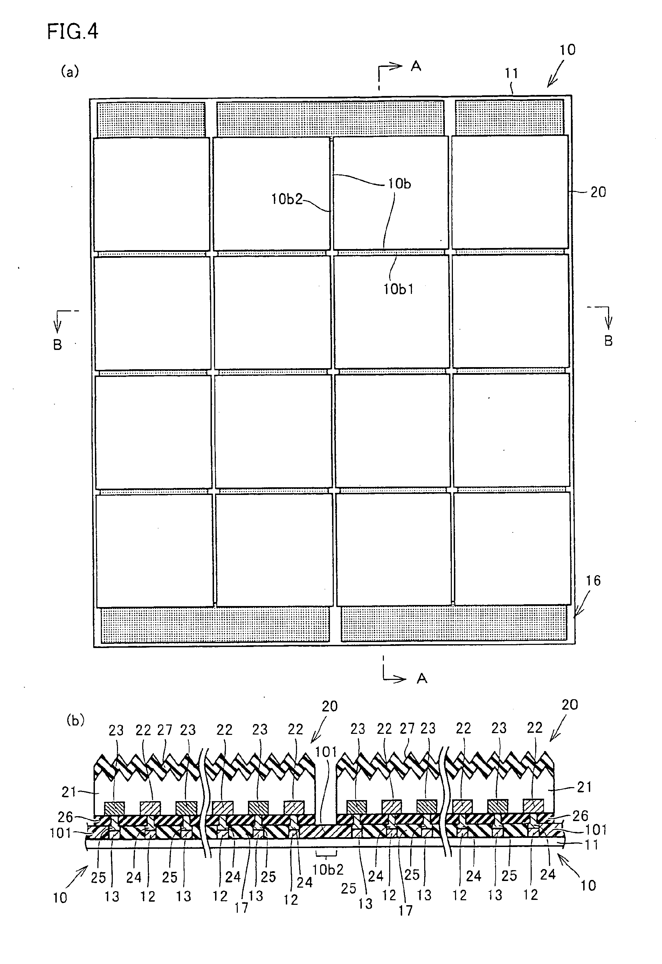

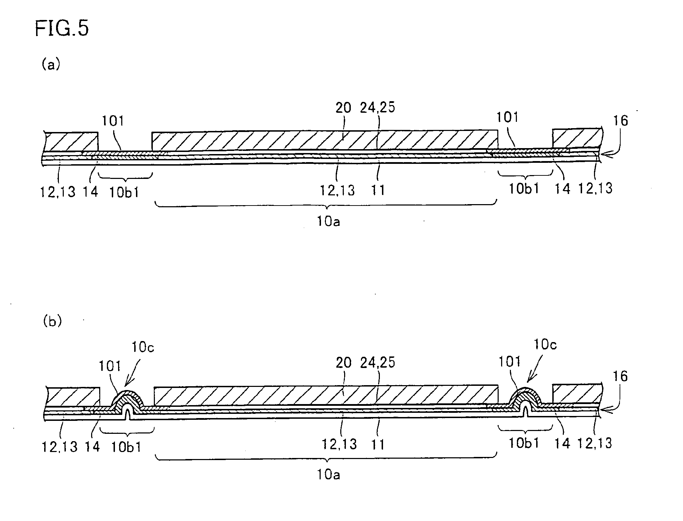

The present wiring sheet has a plane including a cell mounting portion provided with a back electrode type solar cell and is provided with an insulation layer at this plane on a surface of at least a portion of a region excluding the cell mounting portion, and the insulation layer extends to cover at least a portion of a peripheral region of the cell mounting portion, which means that, as shown in Fig. 4(b) and Fig. 5(a), an insulation layer 101 is partially sandwiched between cell 20 and wiring sheet 10. The cell thus has a peripheral portion insulated from the wiring sheet by the insulation layer, and if the cell is flexed or the wiring sheet is deformed or the like and accordingly the cell has a peripheral portion brought into contact with the wiring sheet, the insulation layer prevents such contact and can thus reduce/prevent unwanted contact between the back electrode type solar cell and the wiring sheet.

The present wiring sheet preferably has a plurality of cell mounting portions, and the insulation layer is provided at a portion sandwiched between adjacent cell mounting portions and located at a cell mounting side. In other words, the wiring sheet is **characterized in that** when a solar cell with a wiring sheet or a solar cell module is fabricated, an insulation layer is provided at a portion sandwiched between adjacent cell mounting portions and located at a cell mounting side. The portion between adjacent cell mounting portions is located on the wiring sheet between cell mounting portions provided with back electrode type solar cells, e.g., portions 10b, 10b1, 10b2 on wiring sheet 10 between adjacent cell mounting portions, as shown in Figs. 1, 4 and 5. In other words, it can be said that a portion between adjacent cell mounting portions includes that which does not overlap a cell, as seen in a direction vertical to the cell's major surface (or the wiring sheet's major surface). In the present invention, wiring sheet 10 has an insulation layer at portions 10b1, 10b2 of the wiring sheet sandwiched between cell mounting portions and also closer to the cell, e.g., insulation layer 101 as shown in Figs. 4 and 5.

In the Fig. 4(b) configuration, insulation layer 101 is provided in a direction in which the wirings 12 and 13 teeth extend (i.e., in the vertical direction in Fig. 1(a) and Fig. 4(a)) along an end of a tooth that is located at an end of a set of comb-like forms on a surface of insulating base material 11 located at portion 10b2 sandwiched between adjacent cell mounting portions and located at a cell mounting side. As shown in Fig. 4(b), insulation layer 101 can prevent wiring sheet 10 and back electrode type solar cell 20 from misalignment in a direction orthogonal to that in which the comb-like forms of wirings 12 and 13 extend. While Fig. 4(b) shows insulation layer 101 larger in thickness than wirings 12 and 13, insulation layer 101 may not be larger in thickness than wirings 12 and 13. The latter case also allows the insulation layer to prevent unwanted contact caused between a back electrode type solar cell and the wiring sheet.

Furthermore, in the Fig. 5 configuration, insulation layer 101 is provided on a surface of wirings 12 and 13 located at portion 10b1 sandwiched between adjacent cell mounting portions and located at the cell mounting side, and extends along that end of the wiring for connection 14 closer to the teeth of wirings 12 and 13. Insulation layer 101 is provided in a region including a portion at which the teeth of wirings 12 and 13 are connected to the wiring for connection 14. This can reduce/prevent unwanted contact caused between a back electrode type solar cell and the wiring sheet if the wiring sheet is thermally deformed by a difference between the coefficient of thermal expansion of an insulating material forming the wiring sheet and the coefficient of thermal expansion of a wiring, as will be described hereinafter. Insulation layer 101 has an end on a region extending from an end of the wiring for connection 14 to the tip of the teeth opposite to the end of the wiring for connection 14 (e.g., a region 10e in Fig. 1). As shown in Fig. 5, insulation layer 101 can prevent wiring sheet 10 and back electrode type solar cell 20 from misalignment in a direction orthogonal to that in which the comb-like forms of wirings 12 and 13 extend.

Note that Figs. 4 and 5 show a stage in which back electrode type solar cells 20 are bonded to the wiring sheet, and show insulation layer 101 provided, as seen in a side view. In Figs. 4 and 5, the cell mounting portion corresponds to a portion at which the wiring sheet and back electrode type solar cell 20 are bonded together.

The insulation layer may be formed any material that provides electrical insulation, and may be formed of a variety of known insulating materials. The insulation layer can be provided in a variety of known methods, for example by attaching an insulating member in the form of tape or applying a resin composition that contains epoxy resin, acrylic resin or the like and a curing agent on the cell mounting side between adjacent cell mounting portions via a dispenser, by stamping (or transfer), or by screen-printing, ink jet or the like, and heating or exposing the resin composition to light or the like to set it to provide the insulation layer. The insulation layer may alternatively be provided by slit-coating, spraying, dipping or the like or by subjecting a wiring to blacking processing, an alumite treatment or similar surface processing to serve as an insulation film. The insulation film is provided at a desired position by means of providing the insulation film selectively only at the desired position as well as providing the insulation film in an area that includes the desired position and subsequently removing the unnecessary portion. The insulation layer may be provided before or after the wiring sheet is bonded to back electrode type solar cells.

The insulation layer may have a surface similar in color to the back electrode type solar cell's photoreceptive surface. This allows the back electrode type solar cell to have a less noticeable contour and a solar cell module of a design allowing the cell to be less noticeable in geometry can be fabricated.

Furthermore, the insulation layer may have a white surface. This allows the light incident on a region without a back electrode type solar cell to be reflected and incident on a neighboring back electrode type solar cell, and thus allows a solar cell module to generate electric power more efficiently. Note that the insulation layer may not be white and may have a hue that can reflect the light of a waveform that the back electrode type solar cell can absorb. It is a matter of course that the insulation layer may not be colored and instead be transparent.

The insulation layer may have a surface colored such that the insulation layer is formed of a material per se colored as desired or the insulation layer may underlie a film having a color as desired, or furthermore, the insulation layer may have a surface patterned using two or more types of colors to positively form a design of a solar cell module.

It is preferable to consider the color of the surface of the insulation layer, the position thereof, and the like so that coloring the surface of the insulation layer may not cause inconvenience in a process for fabricating and installing a solar cell module.

For example, if the wiring sheet is provided with a marking for registration in setting back electrode type solar cells on the wiring sheet, then, it is preferable that the insulation layer is transparent, absent or the like on the marking and thus does not make the marking unrecognizable.

Note that insulating base material 11 may be formed of any material that is electrically insulating, and it may be formed for example of a material including at least one type of resin selected from the group consisting of polyethylene terephthalate (PET), polyethylene naphthalate (PEN), polyphenylene sulfide (PPS), polyvinyl fluoride (PVF), and polyimide.

Furthermore, insulating base material 11 may not be limited to any particular value in thickness, and may for example be 25-150 µm.

Note that insulating base material 11 may be formed of a single layer, i.e., have a monolayer structure, or may be formed of two or more layers, i.e., have a multilayer structure.

Furthermore, wiring 16 may be formed of any material that is electrically conductive, e.g., metal including at least one type selected from the group consisting of copper, aluminum and silver.

Furthermore, wiring 16 is also not limited in thickness, and may for example be 15-50 µm.

Furthermore, it is also not needless to say that wiring 16 is also not limited in geometry to that aforementioned and may be set as appropriate.

Furthermore, wiring 16 may have a surface having at least a portion provided for example with an electrically conductive substance including at least one type selected from the group consisting of nickel (Ni), gold (Au), platinum (Pt), palladium (Pd), silver (Ag), tin (Sn), indium (In), SnPb solder, SnBi solder, and indium tin oxide (ITO). This provides a tendency that the wiring sheet 10 wiring 16 and a back electrode type solar cell's electrode as will be described later can be electrically connected satisfactorily and wiring 16 can be enhanced in weather resistance.

Furthermore, wiring 16 may have a surface having at least a portion subjected to blacking processing, rust-proofing, or similar surface processing.

Note that wiring 16 may also be formed of a single layer, i.e., have a monolayer structure, or may be formed of two or more layers, i.e., have a multilayer structure.

Hereinafter will be described one example of a method of fabricating wiring sheet 10 in the configuration shown in Fig. 1(a) and Fig. 1(b).

Initially, insulating base material 11 for example of PET film is prepared and an electrically conductive substance for example in the form of metal foil, metal plate or the like is stuck across one surface of insulating base material 11.

Subsequently, the electrically conductive substance affixed on one surface of insulating base material 11 is partially, photolithographically or similarly etched away and thus patterned to provide on the surface of insulating base material 11 with wiring 16 including the wiring for n type 12. the wiring for p type 13, the wiring for connection 14 and the like formed of the patterned electrically conductive substance.

Wiring sheet 10 configured as shown in Fig. 1(a) and Fig. 1(b) can thus be produced.

Wiring sheet 10 is provided with insulation layer 101 at portion 10b between cell mounting portions, as follows: after the Figs. 1(a) and 1(b) configuration is provided, for example a screen method or a similar printing method is employed to deposit and set an insulating resin material at the cell mounting side on the wirings 12 and 13 of wiring sheet 10 and insulating base material 11 at a portion located at portion 10b sandwiched between cell mounting portions to provide insulation layer 101.

### Back Electrode Type Solar Cell

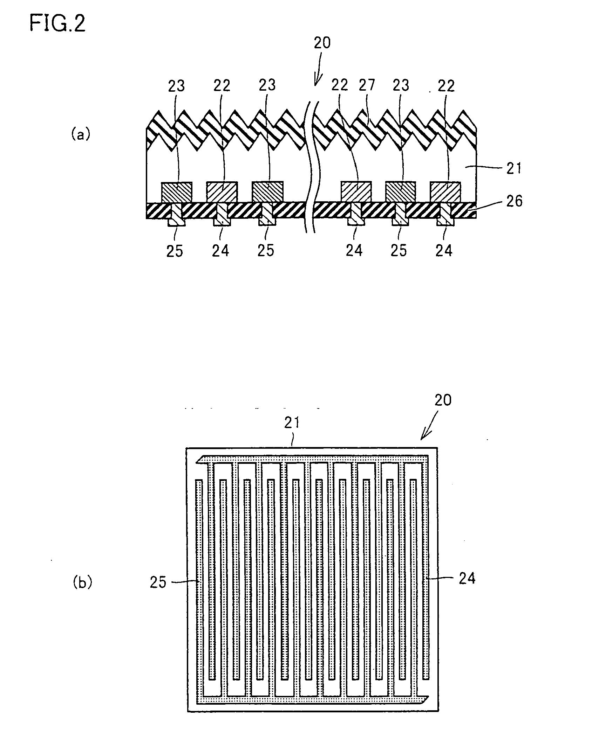

Fig. 2(a) is a schematic cross section of one example of a back electrode type solar cell electrically connected to a wiring of a wiring sheet in accordance with the present invention. Fig. 2(a) shows back electrode type solar cell 20 for example having an n or p type silicon or similar semiconductor substrate 21, an antireflection film 27 provided on an uneven surface of semiconductor substrate 21 serving as a photoreceptive surface of back electrode type solar cell 20, and a passivasion film 26 provided on a back surface of semiconductor substrate 21 serving as a back surface of back electrode type solar cell 20.

Furthermore, semiconductor substrate 21 at the back surface has for example phosphorus or a similar n type impurity and boron or a similar p type impurity diffused therein to have an n type impurity diffusion region 22 and a p type impurity diffusion region 23. respectively, alternately with a predetermined distance therebetween, and is also provided with an electrode for n type 24 and an electrode for p type 25 in contact with n type impurity diffusion region 22 and p type impurity diffusion region 23, respectively, via a contact hole provided through passivasion film 26 provided on the back surface of semiconductor substrate 21.

Herein, The semiconductor substrate 21 back surface of n or p type conduction will have a plurality of pn junctions formed at an interface of n type impurity diffusion region 22 or p type impurity diffusion region 23 and an internal portion of semiconductor substrate 21. Whichever of n type conduction or p type conduction semiconductor substrate 21 may be of, n type impurity diffusion region 22 and p type impurity diffusion region 23 have junction with an internal portion of semiconductor substrate 21 and accordingly the electrode for n type 24 and the electrode for p type 25 will be electrodes corresponding respectively to the plurality of pn junctions provided at the back surface of semiconductor substrate 21.

Fig. 2(b) is a schematic plan view of one example of a back surface of semiconductor substrate 21 of back electrode type solar cell 20 shown in Fig. 2(a). Herein, as shown in Fig. 2(b), the electrode for n type 24 and the electrode for p type 25 are each in the form of a comb and disposed such that the comb-like electrodes for n and p types 24 and 25 have their respective teeth meshed one by one alternately. As a result, the comb-like electrodes for n and p types 24 and 25 have their respective teeth alternately one by one with a predetermined distance interposed.

Herein, the electrode for n type 24 and the electrode for p type 25 provided at the back surface of back electrode type solar cell 20 may have a shape and a position different than Fig. 2(b): they may have any shape and position allowing electrical connection to the wiring sheet 10 wirings for n and p types 12 and 13, respectively.

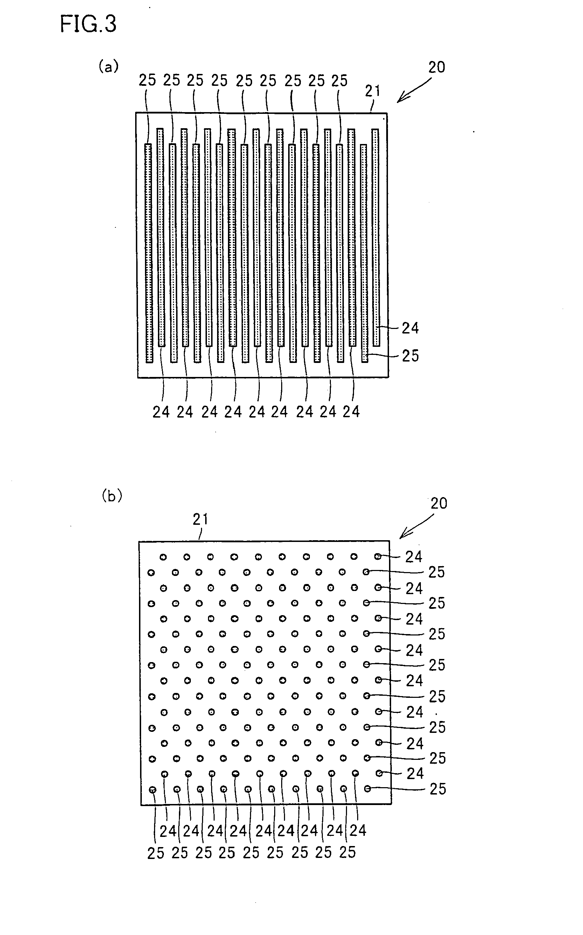

Fig. 3(a) is a schematic plan view of another example of the back surface of semiconductor substrate 21 of back electrode type solar cell 20 shown in Fig. 2(a). As shown in Fig. 3(a), the electrode for n type 24 and the electrode for p type 25 are each formed in a strip extending in the same direction (i.e., the upward/downward direction as seen in Fig. 3(a)) and are alternately disposed, one by one, on the back surface of semiconductor substrate 21 in a direction orthogonal to that in which they extend.

Fig. 3(b) is a schematic plan view of still another example of the back surface of semiconductor substrate 21 of back electrode type solar cell 20 shown in Fig. 2(a). As shown in Fig. 3(b), the electrode for n type 24 and the electrode for p type 25 are each formed in a dot, and a row of dot electrodes for n type 24 (extending upward/downward as seen in Fig. 3(b)) and a row of dot electrodes for p type 25 (extending upward/downward as seen in Fig. 3(b)) are disposed on the back surface of semiconductor substrate 21 alternately.

Furthermore, back electrode type solar cell 20 may have the electrode for n type 24 and/or the electrode for p type 25 with at least a portion thereof having a surface provided for example with an electrically conductive substance including at least one type selected from the group consisting of nickel (Ni), gold (Au), platinum (Pt), palladium (Pd), silver (Ag), tin (Sn), indium (In), SnPb solder, SnBi solder, and indium tin oxide (ITO). This provides a tendency that the wiring sheet 10 wiring 16 and the back electrode type solar cell 20 electrodes (the electrode for n type 24 and the electrode for p type 25) can be electrically connected satisfactorily and the back electrode type solar cell 20 electrodes (the electrode for n type 24 and the electrode for p type 25) can be enhanced in weather resistance.

Furthermore, back electrode type solar cell 20 may have the electrode for n type 24 and/or the electrode for p type 25 with at least a portion thereof having a surface subjected for example to blacking processing, rust-proofing, or similar surface processing.

Semiconductor substrate 21 can be implemented for example as an n or p type polycrystalline or monocrystalline or similar silicon substrate or the like.

The electrode for n type 24 and the electrode for p type 25 can be implemented for example as electrodes formed of metal such as silver.

Passivasion film 26 can be implemented for example as silicon oxide film, silicon nitride film, or silicon oxide film and silicon nitride film stacked in layers, or the like.

Antireflection film 27 can be implemented for example as silicon nitride film or the like.

Note that the concept of the present back electrode type solar cell includes not only a back electrode type solar cell having a semiconductor substrate with only one surface (a back surface) having both an electrode for p type and an electrode for n type, but also a metal wrap through (MWT) cell (i.e., a solar cell having a semiconductor substrate having a through hole receiving a portion of an electrode therein) or a similar, so called back electrode type solar cell (i.e., a solar cell extracting an electric current from a semiconductor substrate's back surface opposite to the semiconductor substrate's photoreceptive surface) or a similar solar cell having an electrode for p type and an electrode for n type both connected to a wiring at one surface side.

### Solar Cell with Wiring Sheet

Fig. 4(a) is a schematic plan view of one example of a solar cell with a wiring sheet in accordance with the present invention, as seen at its photoreceptive surface, and Fig. 4(b) is a schematic cross section taken along a line B-B indicated in Fig. 4(a). In the following description, the present invention provides a solar cell with a wiring sheet in one example such that the Figs. 1(a) and 1(b) wiring sheet 10 has a surface with wiring 16 thereon, with a plurality of back electrode type solar cells 20 shown in Fig. 2(a) and Fig. 2(b) electrically connected thereto. The solar cell with the wiring sheet in accordance with the present invention, however, is not limited in configuration to that shown in Fig. 4(a) and Fig. 4(b).

As shown in Fig. 4(a) and Fig. 4(b), the present invention provides a solar cell with a wiring sheet, that is configured such that back electrode type solar cell 20 is disposed on wiring sheet 10 such that the back electrode type solar cell 20 back surface and the wiring sheet 10 side provided with wiring 16 face each other.

More specifically, as shown in Fig. 4(b), the electrode for n type 24 at the back surface of back electrode type solar cell 20 is bonded to the wiring for n type 12 provided on a surface of insulating base material 11, and the electrode for p type 25 at the back surface of back electrode type solar cell 20 is bonded to the wiring for p type 13 provided on the surface of insulating base material 11. Thus the back electrode type solar cell 20 electrode for n type 24 and the wiring sheet 10 wiring for n type 12 are electrically connected together and so are the back electrode type solar cell 20 electrode for p type 25 and the wiring sheet 10 wiring for p type 13. Note that in Fig. 4 the cell mounting portion corresponds to a portion at which wiring sheet 10 and back electrode type solar cell 20 are bonded together.

As shown in Fig. 1(a), except for the wiring for n type 12a and the wiring for p type 13a each located at an end of wiring sheet 10, adjacent wirings for n and p types 12 and 13 are electrically connected together by the wiring for connection 14 and hence back electrode type solar cells 20 mounted on wiring sheet 10 adjacently will be electrically connected to each other. Accordingly, the Fig. 4(a) and Fig. 4(b) configuration provides solar cells with a wiring sheet such that wiring sheet 10 has back electrode type solar cells 20 mounted thereon all electrically connected in series.

A solar cell, or back electrode type solar cell 20, with a wiring sheet receives light at the photoreceptive surface, and thereby generates an electric current, which is in turn extracted through the back electrode type solar cell 20 electrodes for n and p types 24 and 25 to the wiring sheet 10 wirings for n and p types 12 and 13. The wiring sheet 10 wirings for n and p types 12 and 13 receive the electric current, which is in turn extracted outside the solar cell with the wiring sheet through the wirings for n and p types 12a and 13a each located at an end of wiring sheet 10.

Furthermore, the solar cell with the wiring sheet as described above may be provided for example as shown in Fig. 4(b): curing resin 17 may be introduced between the back electrode type solar cell 20 semiconductor substrate 21 and the wiring sheet 10 insulating base material 11 at a region between the back electrode type solar cell 20 adjacent electrodes for n and p types 24 and 25 to bond back electrode type solar cell 20 and insulating base material 11 more firmly. While Fig. 4(b) shows insulation layer 101 in contact with wirings 12 and 13, curing resin 17 may be posed between insulation layer 101 and wirings 12 and 13.

The present invention provides a solar cell with a wiring sheet, that is **characterized in that** the wiring sheet has a plane including a cell mounting portion provided with a back electrode type solar cell and is provided with an insulation layer at this plane on a surface of at least a portion of a region excluding the cell mounting portion, and the insulation layer extends to cover at least a portion of a peripheral region of the cell mounting portion (i.e., as shown in Fig. 4(b) and Fig. 5(a), insulation layer 101 is partially sandwiched between cell 20 and wiring sheet 10). The cell can thus have a peripheral portion insulated by the insulation layer and if the cell flexes or the wiring sheet is deformed or the like and the cell's peripheral portion is brought into contact with the wiring sheet the insulation layer prevents such contact and can thus reduce/prevent unwanted contact caused between the back electrode type solar cell and a wiring of the wiring sheet.

Furthermore, the solar cell with the wiring sheet in accordance with the present invention is **characterized in that** the wiring sheet is provided with an insulation layer at the cell mounting side of a portion of the wiring sheet that is sandwiched between adjacent cell mounting portions. The portion between adjacent cell mounting portions is as has been described above, and for example, as shown in Fig. 4(a), wiring sheet 10 is provided with insulation layer 101 at portion 10b sandwiched between back electrode type solar cell 20 mounting portions and located at the cell mounting side. Note that herein a solar cell mounting portion is a region of wiring sheet 10 that is provided with solar cell 20 of Fig. 4, as shown in Fig. 1(a) by cell mounting portion 10a, a region of wiring sheet 10 that is provided with solar cell 20, as shown in Fig. 5 by cell mounting portion 10a, and the like.

In the Fig. 4(b) configuration, insulation layer 101 is provided in a direction in which the teeth of wirings 12 and 13 extend (i.e., in the vertical direction in Fig. 1(a) and Fig. 4(a)) along an end of a tooth that is located at an end of a set of comb-like forms on a surface of insulating base material 11 located at portion 10b2 sandwiched between adjacent cell mounting portions and located at a cell mounting side. As shown in Fig. 4(b), insulation layer 101 can prevent wiring sheet 10 and back electrode type solar cell 20 from misalignment in a direction orthogonal to that in which the comb-like forms of wirings 12 and 13 extend. While Fig. 4(b) shows insulation layer 101 larger in thickness than wirings 12 and 13, insulation layer 101 may not be larger in thickness than wirings 12 and 13. The latter case also allows the insulation layer to prevent unwanted contact caused between a back electrode type solar cell and the wiring sheet.

The insulation layer may have a surface similar in color to the back electrode type solar cell's photoreceptive surface. This allows the back electrode type solar cell to have a less noticeable contour and a solar cell module of a design allowing the cell to be less noticeable in geometry can be fabricated.

Furthermore, the insulation layer may have a white surface. This allows the light incident on a region without a back electrode type solar cell to be reflected and incident on a neighboring back electrode type solar cell, and thus allows a solar cell module to generate electric power more efficiently. Note that the insulation layer may not be white and may have a hue that can reflect the light of a waveform that the back electrode type solar cell can absorb. It is a matter of course that the insulation layer may not be colored and instead be transparent.

The insulation layer may have a surface colored such that the insulation layer is formed of a material per se colored as desired or the insulation layer may underlie a film having a color as desired, or furthermore, the insulation layer may have a surface patterned using two or more types of colors to positively form a design of a solar cell module.

It is preferable to consider the color of the surface of the insulation layer, the position thereof, and the like so that coloring the surface of the insulation layer may not cause inconvenience in a process for fabricating and installing a solar cell module.

For example, if the wiring sheet is provided with a marking for registration in setting back electrode type solar cells on the wiring sheet, then, it is preferable that the insulation layer is transparent, absent or the like on the marking and thus does not make the marking unrecognizable.

Fig. 5(a) is a schematic cross section of an example of a solar cell with a wiring sheet in accordance with the present invention, taken along a line A-A indicated in Fig. 4(a). While, as shown in the figure, it is preferable that wiring sheet 10 is provided with insulation layer 101 on that side of the wiring for connection 14 (see Fig. 1) located at portion 10b1 sandwiched between cell mounting portions (see Fig. 4(a). Fig. 5(a)) which is closer to back electrode type solar cell 20, wiring sheet 10 may be provided with insulation layer 101 1 at portion 10b2 between cell mounting portions that does not have any wiring of wiring sheet 10 (see Figs. 4(a), 4 (b)). This configuration effectively reduces/prevents not only contact between cells but also that between a cell and a wiring, and hence insufficient insulation, electrical leakage and short circuit attributed thereto.

Furthermore, as shown in Fig. 5(b), wiring sheet 10 may have a bent portion 10c at the wiring for connection 14 (see Fig. 1) located at portion 10b1 sandwiched between cell mounting portions (see (Fig. 4(a), Fig. 5(a)), and may be provided at the cell mounting side of bent portion 10c with insulation layer 101. In the Fig. 5(b) configuration, by bent portion 10c, wiring sheet 10, as seen in the direction of the thickness of back electrode type solar cell 20 or the wiring sheet, has at least a portion of the portion with insulation layer 101, deformed to be closer to back electrode type solar cell 20 than that portion of wiring sheet 10 which does not have insulation layer 101. This deformation can be caused when wiring sheet 10 and a back electrode type solar cell are bonded together through a heat treatment, as done in a method for fabricating a solar cell with a wiring sheet, as will be described hereinafter. Furthermore, this deformation can also be caused when a solar cell module is sealed in a step involving a heat treatment, as will be described hereinafter.

Hereinafter, how the wiring sheet is thermally deformed will be described. The wiring sheet is configured of an insulating base material and a wiring, which are formed of different materials, respectively, and have different coefficients of thermal expansion, respectively. As such, the wiring sheet at a portion with the insulating base material underlying the wiring will be distorted as temperature varies. Furthermore, the insulating base material is typically implemented as a sheet of a resin material, and when such a resin sheet is heated it can contract, i.e., the resin sheet can thermally contract. On the other hand, the wiring is typically implemented as metal foil, which, when heated, once thermally expands, and thereafter when it is cooled it may not recover its initial dimension. The insulating base material and the wiring thus have such different thermal characteristics, and accordingly, the wiring sheet is thermally deformed.

Furthermore, the wiring sheet's distortion caused between the insulating base material and the wiring as their materials and hence coefficients of thermal expansion are different is caused whenever the wiring sheet's temperature rises/falls, and accordingly, a solar cell module installed outdoor is repeatedly distorted as solar irradiation, climate and the like and hence temperature vary. This distortion becomes stress exerted to the wiring and may break it.

If such thermal deformation is absent, a form as shown in Fig. 5(a) is provided, whereas when such thermal deformation is caused, a form as shown in Fig. 5(b) may be provided. In the Fig. 5(b) case, bent portion 1 0c causes a wiring of wiring sheet 10 located at portion 10b sandwiched between cell mounting portions to approach back electrode type solar cell 20, and if the deformation is significant, the wiring of wiring sheet 10 may be brought into contact with a portion other than an electrode of back electrode type solar cell 20, resulting in unsatisfactory insulation, electrical leakage, and short circuit.

Accordingly, as shown in Fig. 5(b), wiring sheet 10 is provided with insulation layer 101 on the cell mounting side surface of a wiring located at portion 10b sandwiched between cell mounting portions, so that wiring sheet 10 can be prevented from having the wiring brought into contact with a portion other than an electrode of back electrode type solar cell 20. Thus such a configuration as described above effectively prevents the wiring sheet from having a cell and a wiring brought into contact with each other, and hence unsatisfactory insulation, electrical short circuit, and cracking of the cell.

Furthermore in the Figs. 5(a) and 5(b) configuration it is preferable that insulation layer 101 be provided in a region including a portion at which the teeth of wirings 12 and 13 are connected to the wiring for connection 14. The teeth of wirings 12 and 13 and the wiring for connection 14 are connected together as shown in Fig. 1, and the wirings 12 and 13 teeth, which are small in width, extend from one side of wiring 14, which has a relatively large area. When the wiring sheet having a wiring of such a geometry mounted on an insulating base material has the wiring subjected to a stress by such distortion caused between the insulating base material and the wiring, as described above, the teeth of wirings 12 and 13 are significantly deformed lengthwise, whereas the wiring 14, having a relatively large area, is less misaligned from the insulating base material, and accordingly, the stress is concentrated at the connection portion of the teeth of wirings 12 and 13 and the wiring for connection 14, and the wiring is thus breakable. Insulation layer 101 provided at the connection portion of the teeth of wirings 12 and 13 and the wiring for connection 14 can reinforce the wirings and thus prevent stress concentration, and hence the wirings from breakage.

Furthermore, in the Figs. 5(a) and 5(b) configuration, insulation layer 101 is provided on that surface of wirings 12 and 13 located at portion 10b1 I sandwiched between adjacent cell mounting portions which is located at the cell mounting side such that insulation layer 101 is provided along that end of wiring for connection 14 closer the comb-like portions of wirings 12 and 13, and insulation layer 101 has an end on a region extending from an end of the wiring for connection 14 to an end of the teeth opposite to that end of the wiring for connection 14. As shown in Figs. 5(a) and 5(b), such insulation layer 101 can reduce/prevent misalignment between wiring sheet 10 and back electrode type solar cell 20 in a direction in which the wirings 12 and 13 comb-like portions extend (i.e., the vertical direction as seen in Fig. 1 (a) and Fig. 4(a)).

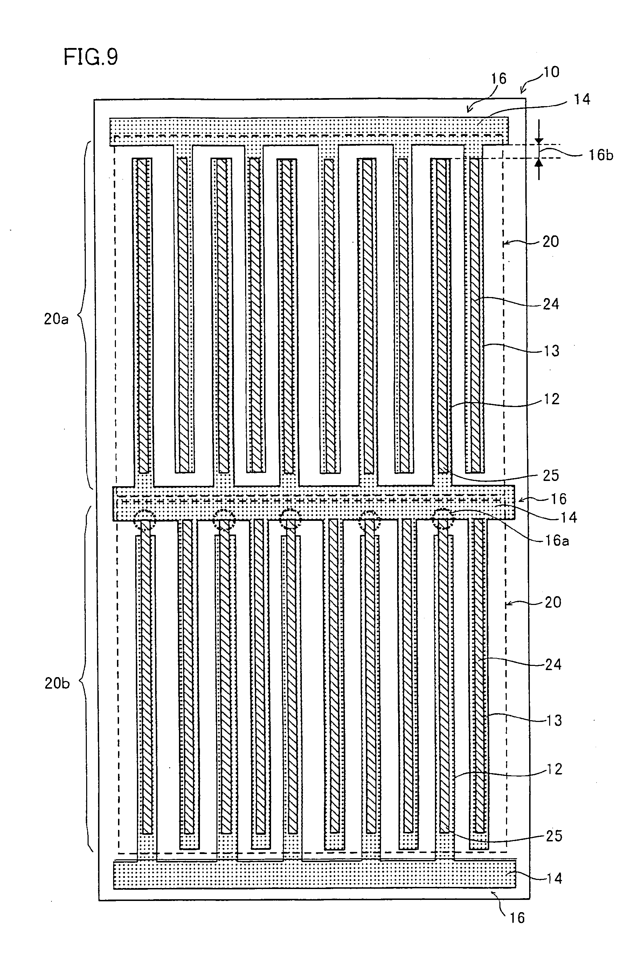

Reference will now be made to Fig. 9 to more specifically describe how to reduce/prevent misalignment of the comb-like portions of wirings 12 and 13 in the direction in which they extend.

As shown in Fig. 9, when electrodes 24, 25 are normally aligned, as shown at a normally connected cell 20a, no short circuit or the like is caused, whereas when electrodes 24, 25 are misaligned in the direction in which wiring 16 extends, as shown at a defective cell 20b, a short circuit will be caused at a short circuit portion 16a.

Note that Fig. 9 shows wiring sheet 10 with back electrode type solar cell 20 mounted thereon, as seen at the cell's side, and to help to understand the positional relationship between wirings 12 and 13 and electrodes 24, 25, the semiconductor substrate of back electrode type solar cell 20 is indicated only by its periphery, as indicated by a dotted line.

This problem can be handled by providing insulation layer 101 as shown in Figs. 5(a) and 5(b) to reduce/prevent misalignment between wiring sheet 10 and back electrode type solar cell 20 causing such short circuit by initial misalignment or the like. This allows a cell to have an electrode provided in a vicinity of an end of the cell and wirings to be spaced by a reduced distance without providing a defective wiring, and a solar cell with a wiring sheet can be fabricated efficiently.

Preferably, the Fig. 9 solar cell with a wiring sheet has wiring sheet 10 provided with insulation layer 101 covering a region of back electrode type solar cell 20 outer than a group of electrodes 24, 25. This can prevent unwanted contact caused between the region of the back electrode type solar cell outer than the group of the electrodes and a wiring of the wiring sheet.

Note that in this example preferably insulation layer 101 has an end within a spacing 16b shown in Fig. 9, since this can prevent back electrode type solar cell 20 from having electrodes 24, 25 brought into contact with the wiring for connection 14 and can prevent back electrode type solar cell 20 and wiring sheet 10 from having electrodes 24, 25 and wirings 12 and 13, respectively, in contact with each other over a reduced area.

### Method for Fabricating Solar cell with Wiring Sheet

In the above described configuration, the back electrode type solar cell 20 electrode for n type 24 and the wiring sheet 10 wiring for n type 12 may be bonded together in any method, and so may the back electrode type solar cell 20 electrode for p type 25 and the wiring sheet 10 wiring for p type 13, and for example they can be bonded together with at least one type of adhesive selected from the group consisting of solder, electrically conductive adhesive, anisotropic conductive film (ACF), anisotropic conductive paste (ACPA), and non conductive paste (NCP). Furthermore, rather than the above adhesives, a sealing material described hereinafter may be used to bond them together.

For example, at least one type of adhesive selected from the group consisting of solder, electrically conductive adhesive, anisotropic conductive film, anisotropic conductive paste, and non conductive paste is applied to a surface of at least one of wiring sheet 10 and back electrode type solar cell 20 and subsequently back electrode type solar cell 20 is disposed on wiring sheet 10 such that the electrode for n type 24 and the wiring for n type 12 are electrically connected together and so are the electrode for p type 25 and the wiring for p type 13.

Then, for example, wiring sheet 10 and back electrode type solar cell 20 are pressed together and in that condition undergo a heat treatment or the like to utilize the adhesive's adhesive strength to bond wiring sheet 10 and back electrode type solar cell 20 together. Thus the back electrode type solar cell 20 electrode for n type 24 and the wiring sheet 10 wiring for n type 12 are fixed and bonded together while they are electrically connected together, and so are the back electrode type solar cell 20 electrode for p type 25 and the wiring sheet 10 wiring for p type 13.

Furthermore, it is needless to say that the above solder, electrically conductive adhesive, anisotropic conductive film, anisotropic conductive paste and other similar electrically conductive adhesive can be applied at a position at which short circuit is not caused in the solar cell with the wiring sheet.

Furthermore, it is needless to say that the above electrically insulating adhesive or a similarly electrically insulating adhesive can be applied at a position that does not prevent electrical conduction of the solar cell with the wiring sheet.

Note that the idea of the solar cell with the wiring sheet in accordance with the present invention includes not only that with wiring sheet 10 having a surface with a plurality of back electrode type solar cells 20 thereon electrically connected together in a line but also that with a plurality of back electrode type solar cells 20 electrically connected together in a form other than a line, e.g.; in a matrix, as shown in Fig. 4(a).

If the solar cell with the wiring sheet in accordance with the present invention is fabricated in a method using solder or thermosetting resin as an adhesive, a heat treatment will be performed to connect the solder or set the resin. Furthermore, if the adhesive is ultraviolet curing resin, a heat treatment will be performed to further cure the adhesive of the ultraviolet curing resin.

When wiring sheet 10 and back electrode type solar cell 20 are bonded through a heat treatment, then, as has been described previously, wiring sheet 10 may deform, for example as shown in Fig. 5(b). However, wiring sheet 10, having insulation layer 101 on the cell mounting side surface of a wiring located at portion 10b sandwiched between cell mounting portions of the wiring sheet, can be prevented from having the wiring brought into contact with a portion of back electrode type solar cell 20 other than an electrode.

Furthermore, the wiring sheet's thermal contraction/expansion can cause misalignment between the wiring sheet and the back electrode type solar cell.

However, as has been described previously, the wiring sheet that has an insulation layer on a surface of a wiring located between cell mounting portions of the wiring sheet that is located at the cell mounting side and an insulation layer on a surface of an insulating substrate located between cell mounting portions of the wiring sheet that is located at the cell mounting side, can reduce/prevent short circuit of the wiring of the wiring sheet and that of the back electrode type solar cell.

### Solar Cell Module

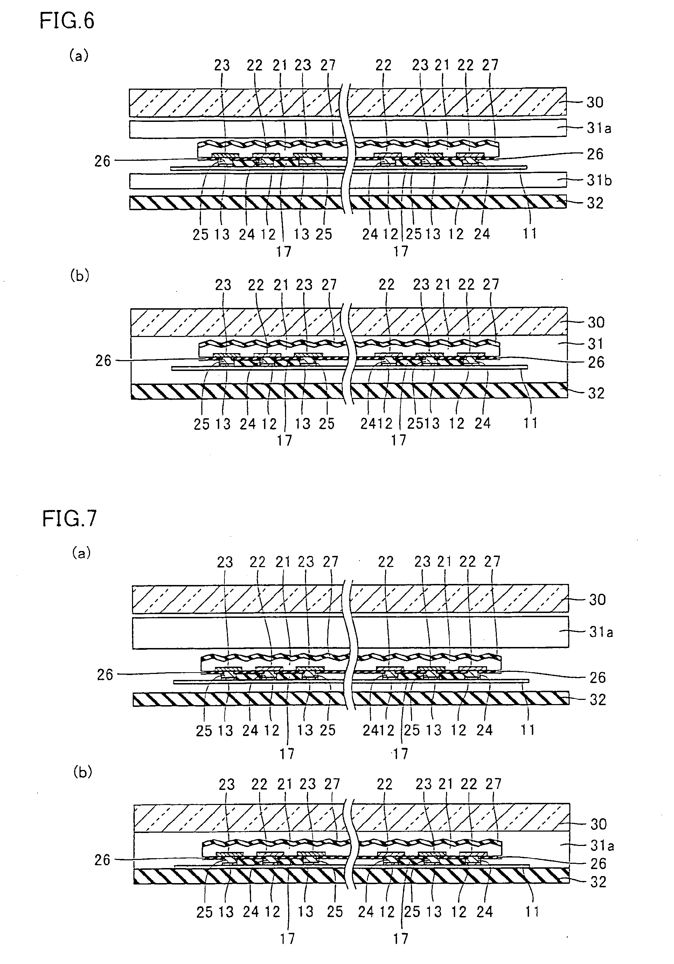

Figs. 6(a) and 6(b) are schematic cross sections each for illustrating one example of a method for fabricating one example of a solar cell module in accordance with the present invention. Hereinafter reference will be made to Fig. 6(a) and Fig. 6(b) to describe one example of the method for fabricating one example of a solar cell module in accordance with the present invention.

While the following will describe as one example of the present solar cell module a solar cell module having sealed in a sealing material a solar cell with a wiring sheet shown in the Fig. 4(a) and Fig. 4(b) configuration, the present solar cell module's configuration is not limited thereto.

Initially, as shown in Fig. 6(a), a transparent substrate 30 with first transparent resin 31a is positioned closer to the solar cell with the wiring sheet configured as shown in Fig. 4(a) and Fig. 4(b), and a back surface protection sheet 32 with second ., transparent resin 31b is positioned closer to the wiring sheet of the solar cell with the wiring sheet configured as shown in Fig. 4(a) and Fig. 4(b).

Then, first transparent resin 31 a is pressed into contact with a back electrode type solar cell of the solar cell with the wiring sheet and second transparent resin 31b is pressed into contact with the wiring sheet of the solar cell with the wiring sheet and they thus undergo a heat treatment to set first transparent resin 31 a and second transparent resin 31b integrally. Thus, as shown in Fig. 6(b), first transparent resin 31 a and second transparent resin 31 b are integrated together to provide sealing material 31 sealing the solar cell with the wiring sheet and thus fabricate one example of the present solar cell module.

In the Fig. 6(b) solar cell module, curing resin 17 provides contractile force which firmly presses the back electrode type solar cell against the wiring sheet and hence more firmly bond the back electrode type solar cell's electrode for n type 24 and the wiring sheet's wiring for n type 12 together and the back electrode type solar cell's electrode for p type 25 and the wiring sheet's wiring for p type 13 together to obtain satisfactory electrical connection between an electrode of the back electrode type solar cell and a wiring of the wiring sheet.

Note that the solar cell with the wiring sheet can be sealed in sealing material 31 through press and a heat treatment for example using equipment referred to as a laminator performing vacuum press and a heat treatment. '

More specifically, for example, the laminator is employed to thermally deform first transparent resin 31 a and second transparent resin 31 b and thermally set first transparent resin 31 a and second transparent resin 31 b to integrate the transparent resins together to provide sealing material 31 to encapsulate and thus seal the solar cell with the wiring sheet therein.

Herein, as the intermediate product is heated, for example the resin sheet that configures the insulating base material of the wiring sheet thermally contracts and on the other hand the metal foil that configures a wiring of the wiring sheet thermally expands, and in that condition, a resin composition 17a, first transparent resin 31 a and the like are set and thus provide constraint and prevent recovery of an initial size. Furthermore, the wiring sheet at cell mounting portions has back electrode type solar cells, which constrain the wiring sheet and accordingly, stress concentrates between adjacent cell mounting portions, and the wiring sheet deforms such that a bent portion is formed between the adjacent cell mounting portions.

Such deformation can cause unwanted contact between a wiring of the wiring sheet and a back electrode type solar cell. However, as has been described previously, such a defect can be prevented by the wiring sheet having an insulation layer on the cell mounting side surface of the wiring between cell mounting portions of the wiring sheet.

Furthermore, the wiring sheet's thermal contraction/expansion can cause misalignment between the wiring sheet and the back electrode type solar cell. However, as has been described previously, the wiring sheet that has an insulation layer on a surface of a wiring located between cell mounting portions of the wiring sheet that is located at the cell mounting side and an insulation layer on a surface of an insulating substrate located between cell mounting portions of the wiring sheet that is located at the cell mounting side, can reduce/prevent short circuit of the wiring of the wiring sheet and that of the back electrode type solar cell.

Note that vacuum press means press in an atmosphere reduced in pressure and thus smaller in pressure than the atmospheric pressure. Note that herein, performing the press by vacuum press is preferable in that it provides a tendency that first transparent resin 31a and second transparent resin 31b have less voids formed therebetween and first transparent resin 31a and second transparent resin 31b integrated together, or sealing material 31, have less air voids remaining therein. Furthermore, vacuum press also provides a tendency to be advantageous in ensuring that the back electrode type solar cell and the wiring sheet are pressed together with uniform force.

Note that transparent substrate 30 may be any substrate that is transparent for solar light and it can for example be a glass substrate.

Furthermore, first transparent resin 31a and second transparent resin 31 b may be any resin that is transparent for solar light, and inter alia, at least one type of transparent resin selected from the group consisting of ethylene vinyl acetate resin, epoxy resin, acrylic resin, urethane resin, olefin resin, polyester resin, silicone resin, polystyrene resin, polycarbonate resin and rubber resin is preferable. In that case, sealing material 31 is excellent in weather resistance and enhanced in permeability for solar light, and can be fixed to transparent substrate 30 with sufficient strength without significantly impairing the solar cell module's output (a short circuit electric current, or a current in operation, in particular). This provides a tendency ensuring that the solar cell module is reliable for a long term.

Note that first transparent resin 31 a and second transparent resin 31 b may be identical or different in type.

Furthermore, when the solar cell with the wiring sheet is sealed in sealing material 31 through a heat treatment and for example first transparent resin 31 a and second transparent resin 31b are both ethylene vinyl acetate resin, the heat treatment can be performed to heat first transparent resin 31a and second transparent resin 31 b for example to 100-200°C.

Furthermore, back surface protection sheet 32 can be any that can protect the back surface of sealing material 31, and can for example be a conventionally used weatherproof film such as PET.

Furthermore, back surface protection sheet 32 may include metallic film for example of aluminum or the like in order to sufficiently reduce/prevent water vapor, oxygen and/or the like transmitted into sealing material 31 and thus ensure long-term reliability.

Furthermore, for the solar cell module's end surface, to which it is difficult to closely attach back surface protection sheet 32, moisture-proof tape such as butyl rubber tape can be used to completely closely attach back surface protection sheet 32 thereto.

Figs. 7(a) and 7(b) are schematic cross sections for illustrating another example of the method for fabricating one example of the solar cell module in accordance with the present invention. Hereinafter reference will be made to Fig. 7(a) and Fig. 7(b) to describe another example of the method for fabricating one example of the solar cell module in accordance with the present invention. While the following will also describe as one example of the present solar cell module a solar cell module having sealed in a sealing material a solar cell with a wiring sheet shown in the Fig. 4(a) and Fig. 4(b) configuration, the present solar cell module's configuration is not limited thereto.

Initially, as shown in Fig. 7(a), back surface protection sheet 32 is alone disposed adjacent to the wiring sheet of the solar cell with the wiring sheet, and transparent substrate 30 with first transparent resin 31 a is disposed adjacent to a back electrode type solar cell of the solar cell with the wiring sheet.

Subsequently, first transparent resin 31a is pressed to the back electrode type solar cell of the solar cell with the wiring sheet and in that condition undergoes a heat treatment to encapsulate and thus seal the solar cell with the wiring sheet in first transparent resin 31 a, as shown in Fig. 7(b). First transparent resin 31 a thus seals the solar cell with the wiring sheet therein and one example of the present solar cell module is thus fabricated.

The Fig. 7(b) solar cell module also has curing resin 17 cured and thus providing contractile force which firmly presses the back electrode type solar cell against the wiring sheet and hence more firmly bond the back electrode type solar cell's electrode for n type 24 and the wiring sheet's wiring for n type 12 together and the back electrode type solar cell's electrode for p type 25 and the wiring sheet's wiring for p type 13 together to obtain satisfactory electrical connection between an electrode of the back electrode type solar cell and a wiring of the wiring sheet.

One example of the present solar cell module thus fabricated has a back electrode type solar cell having a photoreceptive surface to receive light to thereby generate an electric current, which is in turn extracted through the back electrode type solar cell's electrodes for n and p types 24 and 25 to the wiring sheet's wirings for n and p types 12 and 13. The wiring sheet's wirings for n and p types 12 and 13 receive the electric current, which is in turn extracted from the wirings for n and p types 12a and 13a, which are located at an end of wiring sheet 10, as shown in Fig. 1(a), and passed through a terminal electrically connected to wirings for n and p types 12a and 13a, and therefrom output through back surface protection sheet 32 externally.

Furthermore, one example of the present solar cell module thus fabricated may have a frame for example of aluminum alloy attached to surround the solar cell module peripherally.

The present solar cell module is **characterized in that** wiring sheet 10 is provided with an insulation layer at a cell mounting side between adjacent cell mounting portions. The portion between adjacent cell mounting portions is as has been described above, and for example, as shown in Fig. 4(a), wiring sheet 10 is provided with insulation layer 101 at portion 10b sandwiched between back electrode type solar cell 20 mounting portions and located at the cell mounting side.

Herein, as the intermediate product is heated to be sealed, for example the resin sheet that configures the insulating base material of the wiring sheet thermally contracts and on the other hand the metal foil that configures a wiring of the wiring sheet thermally expands, and in that condition, a resin composition 17a, first transparent resin 31 a and the like are set and thus provide constraint and prevent recovery of an initial size. Furthermore, the wiring sheet at cell mounting portions has back electrode type solar cells, which constrain the wiring sheet and accordingly, stress concentrates between adjacent cell mounting portions, and the wiring sheet deforms such that a bent portion is formed between the adjacent cell mounting portions. Such deformation can cause unwanted contact between a wiring of the wiring sheet and a back electrode type solar cell. However, as has been described previously, such a defect can be prevented by the wiring sheet having an insulation layer on a surface of the wiring between cell mounting portions of the wiring sheet.

Note that if the aforementioned wiring sheet having undergone a heat treatment and thus bonded to a back electrode type solar cell as a result has deformation, the subsequent sealing step involving a heat treatment may increase the deformation, or even if the wiring sheet having undergone the heat treatment and thus bonded to the back electrode type solar cell does not have deformation, the subsequent sealing step heats and may thus deform the wiring sheet.

Furthermore, the sealing step heats the wiring sheet and thus causes the wiring sheet to thermally contract/expand and thus misalign from a back electrode type solar cell. However, as has been described previously, the wiring sheet that has an insulation layer on a surface of a wiring located between cell mounting portions of the wiring sheet that is located at the cell mounting side and an insulation layer on a surface of an insulating substrate located between cell mounting portions of the wiring sheet that is located at the cell mounting side, can reduce/prevent short circuit between the wiring of the wiring sheet and the back electrode type solar cell. Furthermore, misalignment caused as the sealing material is fluidized can also be reduced/prevented by these insulation layers.

Note that the wiring sheet may have a portion additionally deformed and may have an existing deformation further deformed and the wiring sheet and a solar cell may have a portion additionally misaligned and may have an existing misalignment further misaligned after the solar cell module has completely been fabricated, as the environment surrounding the product varies in temperature.

In accordance with the present invention, a wiring sheet is provided with an insulation layer on a surface of a wiring between adjacent cell mounting portions of the wiring sheet to reduce/prevent unwanted contact between the wiring of the wiring sheet and a back electrode type solar cell, and hence unsatisfactory insulation, electrical leakage, short circuit, and cracking of the cell, and this allows cells to be spaced by a distance smaller than conventional to achieve more efficient conversion.

### Examples

### Example 1

Initially, as the wiring sheet's insulating base material, a PET film of 510 mm in width, 400 mm in length and 50 µm in thickness was prepared. Then, copper foil of 35 µm in thickness was affixed throughout one surface of the PET film. More specifically, an adhesive was applied to one surface of the PET film and copper foil was superposed thereon, and they were pressurized and heated and thus bonded together.

Then, the copper foil on the surface of the PET film was partially etched and thus patterned in a form as shown in Fig. 1(a) to form wiring 16 including a comb-like wiring for n type 12, a comb-like wiring for p type 13, and a wiring for connection 14 in the form of a strip electrically connecting the wiring for n type 12 and the wiring for p type 13 together. Simultaneously, the wiring for connection 14 (see Fig. 1) was provided with five holes per a length of 125 mm so as to be parallel to solar cells at portion 10b1 (see Fig. 1(a), Fig. 4(a), and Fig. 5(a)) between adjacent cell mounting portions of wiring sheet 10 when the wiring sheet is produced as a solar cell with a wiring sheet or a solar cell module. This hole was provided so that the wiring sheet's thermal deformation causes bent portion 10c as shown in Fig. 5(b).

Then, insulation film was attached throughout a surface of the wiring for connection 14 in the form of the strip of wiring 16 that was located at the cell mounting side to provide an insulation layer. Furthermore, insulating film was stuck to the PET film outside the teeth of an end of wirings 12 and 13 in a direction in which they extend to provide an insulation layer.

Then, resin composition 17a was applied through a dispenser on the wiring sheet 10 wirings for n and p types 12 and 13 at their respective surfaces, and thereafter, 12 back electrode type solar cells 20 were disposed on wiring sheet 10 so that the electrode for n type 24 of back electrode type solar cell 20 of the Fig. 2(a) and Fig. 2(b) configuration was disposed on the wiring sheet 10 wiring for n type 12 and the back electrode type solar cell 20 electrode for p type 25 was disposed on the wiring sheet 10 wiring for p type 13.

Then, a laminator was employed to pressurize and heat resin composition 17a to 150°C to set it to bond the back electrode type solar cell 20 electrode for n type 24 and the wiring sheet 10 wiring for n type 12 together and also bond the back electrode type solar cell 20 electrode for p type 25 and the wiring sheet 10 wiring for p type 13 together to fabricate a solar cell with a wiring sheet.

Thereafter, the solar cell with the wiring sheet fabricated as described above was disposed between ethylene vinyl acetate (EVA) resin placed on a glass substrate and EVA resin placed on PET film. Thereafter, laminator equipment was used and vacuum press was performed to press the glass substrate's EVA resin to back electrode type solar cell 20 with the wiring sheet and press the PET film's EVA resin to wiring sheet 10 of the solar cell with the wiring sheet and in that condition heat the EVA resin to 125°C to set it. The EVA resin set between the glass substrate and the PET film thus sealed the solar cell with the wiring sheet therein to fabricate the solar cell module of example 1. The above heat treatment simultaneously caused stress in wiring sheet 10, which was concentrated at the plurality of holes of the wiring for connection 14 in portion 10b1 between cell mounting portions, and the wiring sheet was deformed to form bent portion 10c projecting toward the back electrode type solar cell, as shown in Fig. 5(b).

The solar cell module of example 1 fabricated as above underwent a temperature cycle test at -40°C to 85°C. While the wiring sheet 10 insulating base material 11 or the PET film thermally contracted, back electrode type solar cells 20 had their spacing substantially unchanged and there was no misalignment of the cells observed, and the solar cell module did not have unsatisfactory insulation, electrical leakage, short circuit, or cracking of a cell, or the like. Furthermore, the solar cell with the wiring sheet in the sealing step was also not observed to have a cell misaligned and did not have unsatisfactory insulation, electrical leakage, short circuit, or cracking of a cell, or the like.

### Example 2

In example 1, a resin composition was used to bond a wiring sheet and a back electrode type solar cell together and subsequently a sealing material was used to seal them to fabricate a solar cell module. In example 2, the wiring sheet and the back electrode type solar cell were not bonded together: they were only sealed with a sealing material to fabricate a solar cell module.

Hereinafter, example 2 will be described only at the portion different than example 1. Example 2 is similar to example 1 until 12 back electrode type solar cells 20 are disposed on wiring sheet 10.

Then, the wiring sheet and solar cells thus stacked in layers were disposed between ethylene vinyl acetate (EVA) resin placed on a glass substrate and EVA resin placed on PET film. Thereafter, laminator equipment was used to press the glass substrate's EVA resin to back electrode type solar cell 20 with the wiring sheet and press the PET film's EVA resin to wiring sheet 10 of the solar cell with the wiring sheet and in that condition heat the EVA resin to 125°C to set it. The EVA resin set between the glass substrate and the PET film thus sealed the solar cell with the wiring sheet therein to fabricate the solar cell module of example 2. The above heat treatment simultaneously caused stress in wiring sheet 10, which was concentrated at the plurality of holes of the wiring for connection 14 in portion 10b1 between cell mounting portions, and similarly as has been described in example 1, the wiring sheet was deformed to form bent portion 10c projecting toward the back electrode type solar cell, as shown in Fig. 5(b).

The solar cell module of example 2 fabricated as above underwent a temperature cycle test at -40°C to 85°C. While the wiring sheet 10 insulating base material 11 or the PET film thermally contracted, back electrode type solar cells 20 had their spacing substantially unchanged and there was no misalignment of the cells observed, and the solar cell module did not have unsatisfactory insulation, electrical leakage, short circuit, or cracking of a cell, or the like. Furthermore, the solar cell with the wiring sheet in the sealing step was also not observed to have a cell misaligned and did not have unsatisfactory insulation, electrical leakage, short circuit, or cracking of a cell, or the like.

### Comparative Example

Comparative examples of solar cells with wiring sheets and solar cell modules similar to those of examples 1 and 2, respectively, were fabricated except that the PET film used for the wiring sheet was not provided with an insulation layer thereon at a cell mounting side between adjacent cell mounting portions when the wiring sheet was fabricated as a solar cell with a wiring sheet or a solar cell module.

The solar cell modules of the comparative examples thus fabricated underwent a sealing step. Their wiring sheets were deformed and it was observed that the wiring sheets had wirings in contact with portions other than electrodes of back electrode type solar cells. Furthermore, after the sealing step, misalignment was visually observed between a cell and a wiring, and this misalignment was of an extent forming short circuit 16a, as has been described with reference to Fig. 9, 20b. These resulted in electrical short circuit.

It should be understood that the embodiments and examples disclosed herein are illustrative and non-restrictive in any respect. The scope of the present invention is defined by the terms of the claims, rather than the description above, and is intended to include any modifications within the scope and meaning equivalent to the terms of the claims.

### INDUSTRIAL APPLICABILITY

The present invention relates to wiring sheets, solar cells with wiring sheets, solar cell modules, methods for fabricating solar cells with wiring sheets, and methods for fabricating solar cell modules.

### REFERENCE SIGNS LIST

10: wiring sheet, 10a: cell mounting portion, 10b: portion between adjacent cell mounting portions, 10c: bent portion, 10d: a plurality of holes, 101: insulation layer, 11: insulating base material, 12, 12a: wiring for n type, 13, 13a: wiring for p type, 14: wiring for connection (or a connection portion), 16: wiring, 17a: resin composition, 17: curing resin, 18: substantially orthogonal direction, 20: back electrode type solar cell, 21: semiconductor substrate, 22: n type impurity diffusion region, 23: p type impurity diffusion region, 24: electrode for n type, 25: electrode for p type, 26: passivasion film, 27: antireflection film, 30: transparent substrate, 31: sealing material, 31 a: first transparent resin, 31b: second transparent resin, 32: back surface protection sheet.

## Claims

1. A wiring sheet (10) comprising an insulating base material (11) and a wiring (16) disposed on said insulating base material (11) for electrically connecting a back electrode type solar cell (20), said wiring sheet (10) having a plane with a cell mounting portion (10a) for mounting said back electrode type solar cell (20) thereon, said wiring sheet (10) being provided with an insulation layer (101) at said plane on a surface of at least a portion of a region excluding said cell mounting portion (10a), said insulation layer (101) extending to cover at least a portion of a peripheral region of said cell mounting portion (10a).

2. The wiring sheet (10) according to claim 1, wherein said insulation layer (101) has a surface similar in color to a photoreceptive surface of said back electrode type solar cell (20).

3. The wiring sheet (10) according to claim 1, wherein said insulation layer (101) has a white surface.

4. The wiring sheet (10) according to any of claims 1-3, further comprising a plurality of cell mounting portions (10a) and provided with said insulation layer (101) between adjacent ones of said cell mounting portions (10a).

5. The wiring sheet (10) according to any of claims 1-3, wherein said insulation layer (101) is provided on said wiring (16).

6. The wiring sheet (10) according to claim 5, wherein:
said wiring (16) includes a comb-like portion formed of a plurality of teeth for electrical connection to said back electrode type solar cell (20) and a connection portion connecting said teeth; and
said insulation layer (101) is provided in a region including a portion at which said teeth are connected to said connection portion.

7. A solar cell with a wiring sheet, comprising:
a wiring sheet (10) having an insulating base material (11) and a wiring (16) provided on said insulating base material (11); and
a back electrode type solar cell (20) having a photoreceptive surface and an opposite surface provided with an electrode,
said wiring sheet (10) being provided with said back electrode type solar cell (20) on a plane, said wiring sheet (10) being provided with an insulation layer (101) at said plane on a surface of at least a portion of a region excluding a cell mounting portion (10a) on which said back electrode type solar cell (20) is mounted, said insulation layer (101) partially extending to said cell mounting portion (10a) between said back electrode type solar cell (20) and said wiring sheet (10).

8. The solar cell with the wiring sheet according to claim 7, wherein said insulation layer (101) has a surface similar in color to said photoreceptive surface of said back electrode type solar cell (20).

9. The solar cell with the wiring sheet according to claim 7, wherein said insulation layer (101) has a white surface.

10. The solar cell with the wiring sheet according to any of claims 7-9, further comprising a plurality of back electrode type solar cells (20) and provided with said insulation layer (101) between adjacent ones of said back electrode type solar cells (20).

11. The solar cell with the wiring sheet according to any of claims 7-9,
wherein said insulation layer (101) is provided on said wiring (16).

12. The solar cell with the wiring sheet according to claim 11, wherein:
said wiring (16) includes a comb-like portion formed of a plurality of teeth and a connection portion connecting said teeth;
said electrode forms a group of electrodes connected to said wiring (16) at said plurality of teeth; and
at least a portion of a region outer than said group of electrodes on a surface of said back electrode type solar cell (20) provided with said group of electrodes is covered with said insulation layer (101).

13. A solar cell module having the solar cell with the wiring sheet of claim 11 sealed with a sealing material.

14. A method for fabricating a solar cell with a wiring sheet, including a wiring sheet (10) having an insulating base material (11) and a wiring (16) provided on said insulating base material (11), and a back electrode type solar cell (20) having a photoreceptive surface and an opposite surface provided with an electrode, comprising the steps of:
providing an insulation layer (101) on a plane having a cell mounting portion (10a) for mounting said back electrode type solar cell (20) thereon; and disposing said back electrode type solar cell (20) on said wiring sheet (10) such that a peripheral region of said back electrode type solar cell (20) is superposed on a portion of said insulation layer (101).
